# EUROPEAN PATENT APPLICATION

(11) **EP 3 133 649 A1**
(43) Date of publication of application: **22.02.2017**
(21) Application number: 15306298.9
(22) Date of filing: 18.08.2015
(51) Int. Cl.: H01L 31/0224

(54) **FLEXIBLE FUNCTIONALIZED FILM**

(71) Applicant: Saint-Gobain Performance Plastics Corporation, Solon, OH 44139 (US)
(72) Inventor: DIGUET, Antoine, Paris 75009 (FR); LEYDER, Charles, 75019 Paris (FR)
(74) Representative: Zimmermann & Partner Patentanwälte mbB

(57) **Abstract**

The invention relates to a flexible film comprising a polymer substrate, a first transparent conductive oxide layer on the substrate, a gold-containing layer on the dielectric layer and an overlayer consisting of a dielectric layer or a second transparent conductive oxide layer on the gold-containing layer, wherein said first transparent conductive oxide layer is based on aluminum-doped zinc oxide.

## Description

### BACKGROUND

The present disclosure relates to a flexible functionalized film and use thereof in window films for solar control applications and/or low-emissivity function.

Transparent conductive films are widely used in many technologies such as flat panels, touch screens, OLED, solar cells, low-emissivity coatings etc. Indium tin oxide (ITO) is the most widely used material. In particular, ITO/metal/ITO stacks have been proposed. Compared to thick ITO monolayers, such stacks have the advantage of reducing the costs due to lower ITO quantity required for achieving equivalent electrical properties as well as providing improved mechanical resistance due to the ductile metallic interlayer. Silver based metallic layers are generally used in those stacks. When turning to specific applications facing corrosion issues, metallic layers based on gold may be preferred. This is particularly the case for window films, where the functional layer may be exposed to ambient atmosphere.

ITO/Au/ITO stacks are thus widely used for window film applications but there is still needs for reducing costs and improving the opto-electrical properties. The use of zinc oxide instead of ITO has been proposed (M. Gitran, Solar Energy Materials & Solar Cells 100, 2012, pp.153-161). Although, the opto-electrical properties were found to be very similar for ITO/Au/ITO and ZnO/Au/ZnO stacks deposited on glass substrates, when the stacks are deposited on PET substrates, the ZnO/Au/ZnO stack does not reach the opto-electrical properties of the ITO/Au/ITO stack.

### DETAILED DESCRIPTION

In one aspect, a flexible functionalized film comprising an oxide/gold/oxide stack having desirable opto-electrical properties is provided. The flexible functionalized film may provide notable benefits by reducing or avoiding of the use of ITO.

According to a first aspect, a flexible functionalized film is provided. The flexible functionalized film comprises:
a polymer substrate;
a first transparent conductive oxide layer on the substrate;
a gold-containing layer on the first transparent conductive layer; and
an overlayer consisting of a dielectric layer or a second transparent conductive oxide layer on the gold-containing layer;
wherein said first transparent conductive oxide layer is based on aluminum-doped zinc oxide.

It has been discovered that when an aluminum-doped zinc oxide layer is disposed under the gold-containing layer, the quality of the gold-containing layer can be improved. For example, embodiments provide improved low emissivity properties.

In the context of the present invention, by the terms "on" and "under" when related to the relative position of one layer or stack to another, it is meant that said layer or stack is more distant from, respectively closer to, the substrate than the other one. It is not meant that said layers or stacks are directly contacting each other, without excluding this possibility. In particular, additional layers may be present between said layers or stacks. On the contrary, the expression "direct contact" when related to the relative position of one layer or stack to another means that no additional layer is disposed between said layers or stacks.

The expression "based on" when referring to the composition of a layer means that said layer comprises at least 80% by weight of the specified material. Other embodiments have more than 90%, such as more than 95% by weight of said material. Said layer may be essentially made of said material, i.e. comprising more than 99% of said material. The expression "made of" when referring to the composition of a layer means that said layer comprises only said material and inevitable impurities.

In the context of the present application, indium tin oxide (ITO) refers to mixed oxide of tin and indium wherein the tin content is generally from 1.5 to 16 wt%, preferably from 4 to 10 wt%. When referring aluminum-doped zinc oxide (AZO), it is meant zinc oxide comprising generally from 0.2 to 5 wt%, preferably from 0.5 to 2 wt%, of aluminum. Tin zinc oxide (TZO) refers to mixed oxide of tin and zinc wherein the tin content is generally from 8 to 70 wt%, preferably from 24%wt to 55%wt. Doped tin oxide refers to tin oxide comprising from 0.2 to 10 wt% of a doping element selected from aluminum, gallium, indium, manganese, iron, cobalt, vanadium.

The polymer substrate is generally a flexible substrate. In a particular embodiment, the polymer substrate does not absorb far infrared radiation. The polymer substrate is for example made of a polymer selected from the group consisting of polyethylene terephtalate, polyethylene naphtalate, polyurethane, polyvinyl butyral, ethylene-vinyl acetate, fluorinated polymers such as ethylene tetrafluoroethylene, or cellulose resin. The thickness of the flexible polymer substrate may be from 5 to 200 µm, preferably from 10 to 100 µm.

The polymer substrate may comprise a hard coat. The hard coat is preferably provided on the top surface on which the functional stack is deposited. The hard coat may be based on silica nanoparticles dispersed in a resin such as an acrylate resin.

The first transparent conductive oxide layer is based on, preferably made of, aluminum-doped-zinc oxide (AZO). The first transparent conductive oxide layer has typically a thickness from 2 to 80 nm.

The gold-containing layer generally contains more than 80%, preferably more than 90%, more preferably more than 95% by weight of gold. It may comprise other metals selected from silver, zinc, copper, aluminum, tin, indium, titanium, chromium, nickel, niobium, rhodium, platinum, palladium. It is advantageously essentially made of gold. The gold-containing layer has typically a thickness from 5 to 20 nm, preferably from 7 to 15 nm. It is preferably in direct contact with the first transparent conductive oxide layer. The gold-containing layer may also be in direct contact with the second transparent conductive oxide layer.

Contrary to the first transparent conductive oxide layer, the overlayer does not have a significant effect on the quality of the gold containing layer. Nevertheless, it still contributes to the low emissivity property of the film, in particular when the overlayer consists of a second transparent conductive oxide layer. In a first embodiment, the overlay can a dielectric layer based on for example on titanium oxide, niobium oxide, nickel chromium oxide, tin oxide or silicon nitride. In a preferred embodiment, the overlayer is a second transparent conductive oxide layer which can be based on any suitable transparent conductive oxide such as ITO, AZO, doped tin oxide or TZO. ITO may however be avoided for a variety of reasons, including economic concerns. In a particular embodiment, the second transparent conductive oxide layer may be based on, preferably made of, AZO. Indeed, despite the lower electrical properties of AZO compared to ITO, AZO/Au/AZO stacks appear to have identical or even better opto-electrical properties than ITO/Au/ITO stacks on polymer substrates. The second transparent conductive oxide layer has typically a thickness from 10 to 80 nm, preferably from 20 to 50 nm.

In an embodiment, the film may further comprise a sublayer between the polymer substrate and the first transparent conductive oxide layer. Preferably, the sublayer is in direct contact with both the polymer substrate and the first transparent conductive oxide layer. The presence of such a sublayer appears to further improve the quality of the gold-containing layer. Without being bound to any theory, it is believed that the surface roughness of the first transparent conductive oxide layer is improved by the presence of the sublayer. The sublayer may be based on a transparent conductive oxide different from AZO and having a lower surface roughness than AZO when deposited on the polymer substrate. Surface roughness, as used herein, is defined as the root mean square roughness as defined in standard ISO 4287:1997. In a particular embodiment, the sublayer may be based on ITO. The sublayer has typically a thickness form 5 to 50 nm, preferably 10 to 30 nm. When the sublayer is present, the first transparent conductive layer has preferably a thickness form 2 to 30 nm, more preferably from 3 to 10 nm. Indeed, the lower the thickness, the lower the surface roughness of the layer. When the sublayer is not present, the first transparent conductive layer has preferably a thickness form 15 to 50 nm.

The film may also comprise a protective layer on the second transparent conductive oxide layer. The protective layer may comprise a silicon-containing layer. The silicon containing-layer may be based on oxide, nitride or oxynitride of silicon. The protective layer has typically a thickness from 5 to 50 nm.

In a particular embodiment, the film comprises, in the following order starting from the polymer substrate:
optionally a sublayer preferably based on ITO;
a first transparent conductive oxide layer based on AZO;
a gold-containing layer;
a second transparent conductive oxide layer preferably based on AZO; and
optionally a protective layer.

Examples of flexible functionalized films according to the invention may comprise the following stacks of layers:
PET/AZO/Au/AZO/Si₃N₄
PET/ITO/AZO/Au/AZO/Si₃N₄
PET/ITO/AZO/Au/ITO/Si3N4

In another aspect, a method for manufacturing a flexible functionalized film comprises the steps of:
providing a flexible polymeric substrate;
depositing on said substrate the following succession of layers:
   a first transparent conductive oxide layer;
   a gold-containing layer; and
   an overlayer consisting of a dielectric layer or a second transparent conductive oxide layer;
wherein said first transparent conductive oxide layer is based on aluminum-doped zinc oxide.

The layers are advantageously deposited by sputtering method, in particular magnetron sputtering, using appropriate coaters and targets.

In another aspect, a glazing, such as a building glazing or a vehicle glazing, comprises a flexible functionalized film according to embodiments described above. The glazing may be a single or a multiple glazing, in particular a double or triple glazing. The film n may be provided on the surface of the glazing facing the inside. In particular, the film may be generally provided on the glazing by contacting the surface of the film closest to the polymer substrate with the surface of the glazing facing the inside. Nevertheless, when the flexible polymer substrate does not absorb far infrared radiations, the film may be provided on the glazing by contacting the surface of the film furthest from the flexible polymer substrate with the surface of the glazing facing the inside. In such an embodiment, the film may comprise a counter flexible polymer substrate provided on the overlayer through a pressure adhesive layer.

In another aspect, a method for manufacturing a glazing comprises the step of providing the flexible functionalized film on the surface of the glazing. The film of the present invention may be laminated on the glazing and adhered to the glazing through a pressure sensitive adhesive layer.

In another aspect, a method for improving the low emissivity property of a glazing, such as building glazings or vehicle glazings, comprises the step of providing the flexible functionalized film on the surface of the glazing.

Embodiments of the flexible functionalized film of the present invention will now be illustrated with the following non-limiting examples.

### Examples

Four flexible functionalized films have been prepared. Sample A is a comparative example wherein ITO is used for the first and second transparent conductive oxide layers. Samples B, C and D are flexible functionalized films according to the invention wherein AZO is used for the first transparent conductive oxide layers. Samples C and D further comprise a sublayer made of ITO.

The thin layers have been deposited by magnetron sputtering on a PET substrate.

Table 1 shows the operating conditions for the magnetron sputtering deposition for each type of layer.

**Table 1**

| Layer | Target | Operating pressure | Gas |
|---|---|---|---|
| AZO | AZO 2%wt Al203 | 2 µBar | Ar |
| ITO | ITO In2O3/SnO2 90/10 %wt | 2 µBar | Ar + O₂ (3.75 mol%) |
| Au | Au | 8 µbar | Ar |
| Si₃N₄ | Si-Al 92/8%wt | 1,5 µbar | Ar + N₂ (54.8 mol%) |

Table 2 shows the compositions, the order and the thickness of the layers of the stacks for each sample, as well as the opto-electrical properties of the films.

The sheet resistance (Rsq) has been measured with a non-contact measurement by induction with SRM-12 apparatus from Nagy.

The absorbance (A) has been measured with a flash spectrophotometer CM-3700d from Konika-Minolta following the standard ISO 9050:2003.

The emissivity (ε) has been measured according to the standard EN 673:2011 with FT-IR spectrophotometer Spectrum 100 76500 from Perkin Elmer.

**Table 2**

| Composition | Thickness (nm) | | | |
|---|---|---|---|---|
| | A | B | C | D |
| AZO | - | 25 | - | 25 |
| ITO | 25 | - | 25 | - |
| Au | 10 | | | |
| AZO | - | 25 | 5 | 5 |
| ITO | 25 | - | 20 | 20 |
| PET Substrate | 50 µm | | | |
| Rsq (Ohm/sq) | 8.46 | 7.5 | 7.32 | 7.07 |
| A (%) | 21.99 | 21.18 | 21.67 | 19.86 |
| ε (%) | 9.15 | 8.18 | 8.01 | 7.77 |

The use of AZO instead of ITO in the film B results in desirable opto-electrical properties compared to the film A. The use of an ITO sublayer between the PET substrate and the first AZO layer in the films C and D further improves the opto-electrical properties of the films according to embodiments herein.

## Claims

1. A flexible functionalized film comprising a polymer substrate, a first transparent conductive oxide layer on the substrate, a gold-containing layer on the first transparent conductive oxide layer, and an overlayer consisting in a dielectric layer or a second transparent conductive oxide layer on the gold-containing layer, wherein said first transparent conductive oxide layer is based on aluminum-doped zinc oxide.

2. The film according to claim 1, wherein the first transparent conductive oxide layer is in direct contact with the gold-containing layer.

3. The film according to claim 1 or 2 comprising a sublayer between the polymer substrate and the first transparent conductive oxide layer.

4. The film according to claim 3, wherein the sublayer is based on indium tin oxide.

5. The film according to any one of claims 3 or 4, wherein the sublayer has a physical thickness from 5 to 50 nm.

6. The film according to any one of claims 1 to 5, wherein the first transparent conductive oxide layer has a physical thickness from 2 to 80 nm.

7. The film according to any one of claims 1 to 6, wherein the overlayer consists in a second transparent conductive oxide layer based on aluminum-doped zinc oxide.

8. The film according to any one of claims 1 to 7, wherein the overlayer has a physical thickness from 10 to 80 nm.

9. The film according to any one of claims 1 to 8, wherein the gold-containing layer has a physical thickness from 5 to 20 nm.

10. The film according to any one of claims 1 to 9 comprising a protective layer on the overlayer.

11. The film according to claim 10, wherein the protective layer comprises a silicon-containing layer.

12. The film according to claim 10 or 11, wherein the protective layer has a physical thickness from 5 to 50 nm.

13. A glazing comprising the film according to any one of claims 1 to 12.
